# EUROPEAN PATENT SPECIFICATION

(11) **EP 2 934 946 B1**
(45) Date of publication and mention of the grant of the patent: **14.10.2020**
(21) Application number: 13818219.1
(22) Date of filing: 20.12.2013
(51) Int. Cl.: G01R 31/00, B60Q 1/30, B60Q 11/00

(54) **MEASUMEMENT MODULE FOR ELECTRONIC INTERFACE DEVICE FOR CONNECTING A TRAILER LIGHTING SYSTEM TO A VEHICLE LIGHTING SYSTEM**
MESSMODUL FÜR EINE ELEKTRONISCHE SCHNITTSTELLENVORRICHTUNG ZUR VERBINDUNG EINES ANHÄNGERBELEUCHTUNGSSYSTEMS MIT EINEM FAHRZEUGBELEUCHTUNGSSYSTEM
MODULE DE MESURE POUR UN DISPOSITIF D'INTERFACE ÉLECTRONIQUE POUR CONNECTER UN SYSTÈME D'ÉCLAIRAGE DE REMORQUE À UN SYSTÈME D'ÉCLAIRAGE DE VÉHICULE

(30) Priority: 24.12.2012 NL 2010053
(43) Date of publication of application: 28.10.2015
(73) Proprietor: ECS Electronics B.V., 4825 AR Breda (NL)
(72) Inventor: DE BRUIJN, Peter, 4817 KW Breda (NL); DEKKERS, Martinus Hubertus Cornelis Marie, 4931 HB Geertruidenberg (NL); VERHAGEN, Cornelis Adriaan Arnold Marie, 5658 RN Eindhoven (NL)
(74) Representative: DeltaPatents B.V.
(86) International application number: PCT/EP2013/077593
(87) International publication number: WO 2014/102171

(56) References cited:
- EP-A1- 0 483 650
- DE-A1- 10 033 345
- US-A1- 2010 152 989
- US-A1- 2017 285 084

## Description

### FIELD OF THE INVENTION

The invention relates to a measurement module for an electronic interface device for connecting an auxiliary lighting system, such as a trailer lighting system.

### BACKGROUND OF THE INVENTION

When connecting e.g. a trailer to a vehicle, it is required to connect the trailer lighting system to the vehicle lighting system in such a manner that the lamps of the trailer are operated in accordance with the corresponding lights of the vehicle. For example, the rear lights, the left and right indicator lights and the brake light(s) of the trailer have to illuminate together with the rear lights, the left and right indicator lights and the brake light(s) of the vehicle to which the trailer is connected. It may further be required for some lamps that specific lamps are only illuminated on the trailer, while the corresponding lamp of the vehicle remains dark. For example, legislation may require that the fog lamp of the vehicle is not illuminated once a trailer is connected to the vehicle. Similarly, when other devices are connected to the vehicle's tow bar, such as a bicycle carrier rack, the bicycle rack may hamper visibility of the vehicle's light, and it may be necessary to also connect an auxiliary lighting system in a similar manner as when connecting a trailer. It may further be required, for example by national legislation, that a control is performed as to a correct performance of the trailer indicator lights when a trailer is connected, a so-called C2 control. Where the control detects that one of the indicator lights of the trailer is broken, the legislation may then require that the driver of the vehicle is informed by, e.g., a double-frequency of flashing of the associated dashboard control light or by an audible signal.

Hereto, it is known to use an electronic interface device for connecting an auxiliary lighting system, such as a trailer lighting system, to a vehicle lighting system of a vehicle and driving the auxiliary lighting system from the vehicle lighting system. In known systems, the interface device may comprise an input power terminal for electrically connecting to a power supply circuit in the vehicle, an output power terminal for electrically connecting to the auxiliary lighting system, a control terminal for electrically connecting to the vehicle lighting system for receiving a control signal corresponding to an operation of a lamp of the vehicle lighting system, a semiconductor driving device electrically connected to the input power terminal and to the control terminal for selectively connecting the output power terminal to the input power terminal in dependence on the control signal for operating a lamp of the auxiliary lighting system corresponding to the lamp of the vehicle lighting system, and a tow bar cable extending from a tow bar cable end to the output power terminal. The input power terminal may e.g. be a cable end of a 2.5 mm² power cable that is connected in the vehicle's fuse box to the vehicle's power supply circuit to obtain power from the vehicle's battery. The output power terminal is provided at the other end of tow bar cable and connects to a pin in a tow bar socket connector, such as e.g. the corresponding pin in a seven-pin connector defined in the seven-pin trailer connection system ISO 1724 or a thirteen-pin connector defined in the thirteen-pin trailer connection system DIN 11446:2004, or extended or alternative connectors. The control terminal may e.g. be a control cable end connecting to the vehicle's lighting control signal lines, e.g. using T-shaped connectors, such as an analogue line or a CAN-bus. The semiconductor driving device may in particular be a Power Transistor, such as a MOSFET power transistor. Some known interface devices directly connect the control cable with its control signal to the semiconductor driving device, while other known interface devices connect the control cable with its control signal to the semiconductor driving device via a microcontroller which may e.g. transform the control signal to a signal suitable for operating the semiconductor driving device. Typically, a lamp of a vehicle as well as a lamp of a trailer is operated at the battery voltage of the vehicle, i.e. at 9 - 14V, and a current in the range of 5 - 7 A. In particular the control signal may correspond to a signal of an in-vehicle bus, such as a CAN-bus. As however vehicles from different vehicle manufacturers do not all use the same CAN-bus configuration, a CAN-bus interface module of the interface device is then usually programmed by the manufacturer of the interface device or by a tow bar installer, and using an external configuration system (e.g., a computer), to configure the CAN-bus interface module via a microcontroller of the interface device into a configuration that matches the specific vehicle type (e.g., communication protocol, signal level polarities, operation frequency). The CAN-bus interface may e.g. be programmed to provide a vehicle-type specific warning message on the CAN-bus to indicate that the C2 control detected an error of one or more trailer indicator lights when a trailer is connected, to hereby allow e.g. a dashboard controller to signal the driver double-frequency of flashing of the associated dashboard control light or by an audible warning signal. The programming may comprise loading a vehicle type specific program code into the CAN-bus interface module and/or the microcontroller of the interface device. The programming may additionally or alternatively comprise conditioning the CAN-bus interface module, e.g. by setting an internal one-time programmable memory element to a vehicle type specific value, to hereby activate one configuration of a plurality of pre-programmed CAN-bus interface configurations. The CAN-bus interface of the interface module may hereby be programmed or conditioned so as to be correctly integrated into the in-vehicle network. The programming and/or conditioning may also comprise programming and/or conditioning other CAN-bus interfaces in the in-vehicle network to operate in a mode that is compatible with a connected trailer, such as an Anti-lock Braking System (ABS), an Electronic Stability Control (ESC) or Electronic Stability Program (ESP), a Trailer Stability Program (TSP) and/or systems for cooling or transmission.

After a user, such as a driver of the vehicle, has connected a trailer to a vehicle and inserted the 7- or 13-pole plug of the trailer lighting system in the associated tow bar socket connector to connect the trailer lighting system to the vehicle lighting system, the user has to check whether the lamps of the trailer are well connected and operate correctly. Likewise, when a tow bar installer, dealer or car repairman installs a tow bar and the associated tow bar module into the car, he has to check whether he installed it all correctly. In known systems, the user (driver) hereto usually goes through a sequence of putting the vehicle lighting system in different states when sitting in the driver seat (e.g., successively turning one on out of a left indicator light, a right indicator light, a left and right rear light, a brake light, a fog light, a reserve light) and then asks another person whether the intended lamps lighten up correctly for each of the states and/or he leaves his driver seat to check the lamps at the rear of the trailer himself for each of the states. Similarly, when an installer installs a tow bar, the installer usually connects a test box having a corresponding set of lamps as an actual trailer, and performs a similar test procedure as described for the driver. During this visual checking as to whether the correct lamps light up, it is usually difficult to also check whether the brightness of the lamps is still sufficient. For example, when the lamp comprises a plurality of LEDs of which the light output is mixed in lamp optics so as to provide a homogenous light beam, it may be difficult to detect that the overall brightness has dropped below legally allowed lower limits (typically, down to 70% or less of the initial brightness) due to ageing of individual LEDs or a complete loss of one or more LEDs.

US patent application US 2010/152989 A1 describes a trailer mounted proportional brake controller for a towed vehicle and a method of controlling the brakes of a towed vehicle. A trailer mounted proportional brake controller for a towed vehicle and a method of controlling the brakes of a towed vehicle is described. The brake control unit may control the brakes of a towed vehicle. The brake control unit may include a power control unit and a hand control unit. The power control unit may be connected to the brakes of the towed vehicle and the power control unit may be capable of selectively controlling the brakes of the towed vehicle based on a set of braking parameters. The hand control unit may be configured to remotely communicate with the power control unit. The hand control unit may be capable of transmitting information to the power control unit to adjust at least one of the braking parameters and receiving information from the power control unit.

### SUMMARY OF THE INVENTION

It would be advantageous to have an improved interface device. In particular may it be a wish to have an interface device which allows informing a user, such as a driver or an installer, about a status of the auxiliary lighting system, such as a condition of the lamps of the trailer.

To better address at least one of these wishes, a first aspect of the disclosure not forming part of the claimed invention provides an electronic interface device for connecting an auxiliary lighting system, such as a trailer lighting system, to a vehicle lighting system of a vehicle and driving the auxiliary lighting system from the vehicle lighting system, the interface device comprising an output power terminal for electrically connecting to the auxiliary lighting system via a tow bar cable, a control terminal for electrically connecting to the vehicle lighting system for receiving a control signal corresponding to an operation of a lamp of the vehicle lighting system, a semiconductor driving device electrically connected to the control terminal for selectively driving the output power terminal in dependence on the control signal for providing a trailer lamp drive signal for operating a lamp of the auxiliary lighting system corresponding to the lamp of the vehicle lighting system, the control signal being in a drive state selected from at least a driven state and a non-driven state, a measurement circuit for obtaining a measurement value of at least one electrical parameter indicative of a performance of the lamp of the auxiliary lighting system during at least part of the driven state, and a wireless interface for communication with a remote user device. The electronic interface device also comprises a processor arranged for sending, via the wireless interface, a signal indicative of the measurement value of the at least one electrical parameter to a user device to allow the user device to inform a user of the measurement value of the at least one electrical parameter or an indicator derived thereof.

By obtaining a measurement value of the at least one electrical parameter, such as a drive current drawn from the output power terminal during the driven state, and transmitting this measurement value to the user device, the user can inspect either directly the measurement value as obtained by the measurement circuit and compare the measurement value with an expected value, or the user can let the user device interpret the received measurement value to inform the user with a simple "OK" or "not OK" message using a visible indicator (symbol, word, text message) or an audible indicator (beep, spoken word).

Using a wireless interface may be advantageous as the number of external connections (pins) of the electronic interface device can remain unchanged.

Using a wireless interface may be advantageous as the signal indicative of the measurement value of the at least one electrical parameter may be received by user devices that is external from the vehicle and/or the trailer, and/or at a distance from the vehicle and/or the trailer.

Using a wireless interface may enable communication with a user device that is not specifically designed to be connected to an in-vehicle network or in-vehicle bus. This may in particular be advantageous where the wireless interface is arranged to transmit using a standardized wireless communication, in particular when using a widely used wireless communication standard. Such standardized or widely used communication standard may e.g. be a 2,4 GHz band radio transmission, wireless communication according to wireless local area network (WLAN) computer communication in the 2.4, 3.6 and 5 GHz frequency bands (also known as WiFi) according to e.g., the IEEE 802.1 1a, 802.11b, 802.11g, 802.11n, 802.11ac and 802.11ag standards, short distance wireless communication (using short-wavelength radio transmissions in the so-called ISM band from 2400-2480 MHz) creating so-called personal area networks (PANs) with high levels of security such as using the Bluetooth standard as currently managed by the Bluetooth Special Interest Group, or so-called near-field communication (NFC) standards which are based on radio-frequency identification (RFID) standards such as ISO/IEC 14443, ISO/IEC 18092 and/or standards defined by the so-called NFC Forum. The user device may be, e.g., a 2.4 GHz radio receiver equipped, a WLAN-equipped, a WiFi-equipped,, a Bluetooth equipped or a NFC equipped user device, such as a smartphone, a tablet computer, a general purpose laptop computer or a dedicated measurement device or a dedicated monitor device. The user device may in particular be a user device capable of installing and executing programs thereon, such as a smartphone, a tablet computer or a general purpose laptop computer. The user may then be informed about the measurement value of the at least one electrical parameter or an indicator derived thereof by executing a suitably designed program that is installed on the user device capable of installing and executing programs thereon. E.g., the user may be informed by a suitable programmed "app" after having installed such "app" on his smartphone.

The measurement value may correspond to a voltage value, a current value, a resistance value, a consumed power value or any equivalent measurement value. The measurement value may directly correspond to the electrical parameter as measured, or be converted into different units, inverted or classified into certain grades (such as "poor", "acceptable", "good").

In selectively driving the output power terminal in dependence on the control signal, the output power terminal may selectively supply a voltage or a current in dependence on voltage or current conditions according to corresponding control parameters in the control signal. The semiconductor driving device may e.g. be a high-power transistor, such as a MOSFET or JFET, or a circuit arrangement comprising e.g. such high-power transistor.

The interface device may also be referred to as tow bar module.

The measurement circuit may be connected to the output power terminal, to hereby directly measure on the side of the semiconductor driving device where the lamp of the trailer is connected to.

The interface device may further comprise an input power terminal for electrically connecting to a power supply circuit in the vehicle and a reference power terminal for providing a reference voltage. The semiconductor driving device may comprise a semiconductor switching device electrically connected to the input power terminal and to the control terminal for selectively connecting the output power terminal to either the input power terminal or the reference terminal in dependence on the control signal.

In selectively driving the output power terminal from the input terminal, the semiconductor driving device may selectively switch the output terminal to the input terminal or the reference terminal (such as ground). In selectively driving the output power terminal from the input terminal, the semiconductor driving device may alternatively selectively drive the output terminal from the input terminal or a reference terminal (such as ground) while applying a positive or negative gain and/or a polarity control (e.g., a polarity switch). The semiconductor driving device may e.g. be a high-power switch or a high-power transistor, such as a MOSFET or JFET.

The processor may be further arranged for receiving test control signals, via the wireless interface, from a measurement module and for controlling the semiconductor driving device using the test control signals. This will enable a test procedure in which the switching of the semiconductor driving device is controlled by the measurement module in e.g. a measurement box attached to the vehicle, instead of by a user sitting in the driver seat.

The measurement circuit may be connected to the input power terminal or the output terminal, to hereby measure, e.g., the current drawn through the semiconductor driving device by the lamp of the trailer.

In an embodiment, the interface device further comprises a control bus interface and a processor, the control bus interface being connected between the control terminal and the semiconductor driving device, the control bus interface being arranged to receive the control signal, to transform the control signal (e.g., by decoding an encoded signal into a binary signal) into a transformed control signal and to control the semiconductor driving device using the transformed control signal. The control signal may, for example, be a signal on an in-vehicle bus, such as a CAN-bus. The transformed control signal may, for example, be a binary signal at appropriate signal level and signal polarity to operate the semiconductor driving device so as to operating the lamp of the auxiliary lighting system corresponding to the lamp of the vehicle lighting system.

In a further embodiment, the control signal may be a component of a CAN-bus signal and the control bus interface may be a CAN-bus interface.

CAN-bus is widely used throughout the vehicle manufacture industry to accommodate for in-vehicle communication and control of lighting, as well as other components of a vehicle, such as motors for opening and closing the windows. However, not all vehicle manufacturers use the same logical signals for the same or corresponding controls. Hereto, a further embodiment provides for the a wireless interface further being arranged for receiving a control bus interface programming information (such as CAN-bus programming information), and the control bus interface is arranged to be configured in dependence on the control bus interface programming information. Hereby, the installer of the tow bar module may configure the control bus interface with the appropriate settings for a specific vehicle brand or type.

In a further embodiment, the control signal may be a component of an in-vehicle LAN signal and the control bus interface may be a LAN interface.

In an embodiment, the interface device further comprises a programmable processor connected to the measurement circuit and/or the control bus interface and/or the semiconductor driving device, the programmable processor being arranged to receive the control bus interface programming information from the wireless interface and configure the control bus interface in dependence on the control bus interface programming information; and/or receive the measurement value of at least one electrical parameter indicative of the performance of the lamp of the auxiliary lighting system during at least part of the driven state from the measurement circuit, process the measurement value into a performance indicator, and providing the performance indicator to the wireless interface for transmitting the performance indicator as part of the signal.

In a further embodiment, the interface device further comprises a memory, the memory being connected to the programmable processor, the programmable processor being arranged to store and retrieve the measurement value of at least one electrical parameter of successive measurement values in/from the memory and/or to store in and retrieve the performance indicator in/from the memory as historical data. Hereby, deviations over time, such as ageing effects, may be detected and signaled.

In a further embodiment, the processor is arranged to process the measurement value into a performance indicator using at least part of the historical data. Hereby, deviations over time, such as ageing effects, may be detected and signaled.

A second aspect not forming part of the claimed invention provides a lighting system comprising a vehicle lighting system, an auxiliary lighting system, such as a trailer lighting system, and an interface device according to any one of the embodiments described above, the interface device electrically connecting the auxiliary lighting system to the vehicle lighting system and arranged to drive the auxiliary lighting system from the vehicle lighting system.

A third aspect not forming part of the claimed invention provides a vehicle comprising a vehicle lighting system and an interface device according to any one of the embodiments described above, the electronic interface device being arranged to connect an auxiliary lighting system, such as a trailer lighting system, to the vehicle lighting system of the vehicle and to, when connected, drive the auxiliary lighting system from the vehicle lighting system.

A fourth aspect not forming part of the claimed invention provides a user device comprising a user device wireless interface for receiving the signal indicative of the measurement value of the at least one electrical parameter; a signal processor arranged to process the signal as received by the user device wireless interface and to derive an indicator of the measurement value of the at least one electrical parameter; and an indicator device for informing a user of the indicator.

In an embodiment, the indicator device comprises a visual indicator device, such as an electronic display and/or an indicator light.

Alternatively the indicator device may comprise an audible indicator device, such as a speaker arranged to provide a sound, a retrieved spoken word, a retrieved spoken message, a synthesized spoken word or a synthesized spoken message.

The user device may be a mobile phone, a tablet computer, a laptop computer or a personal computer.

In an embodiment, the signal processor of the user device comprises a programmable signal processor, the programmable signal processor being arranged to process the signal as received by the user device wireless interface, derive the indicator from the measurement value of the at least one electrical parameter and, in a further embodiment, format the indicator into a form suitable for the indicator device.

For example, the user device may be a mobile phone and the signal processor may be programmed with a computer program product of a form currently referred to as a so-called app, where the app can display the indicator on a display of the mobile phone. The indicator may, e.g., schematically represent a view of the trailer lamps and indicate graphically for each trailer lamps whether the respective trailer lamp operated correctly (e.g., by showing the lamp in a green color), incorrectly (e.g., by showing the lamp in a red color) or whether further attention is needed (e.g., by showing the lamp in an orange color, or by showing a warning sign).

Instead of informing the user of the indicator on site, the user device may forward the measurement value and/or the indicator to a remote user interaction system where the received information can be analyzed by skilled persons interacting with the user interaction system.

The user device may be, e.g., a 2.4 GHz radio receiver equipped, a WLAN-equipped, a WiFi-equipped, a Bluetooth-equipped or a NFC-equipped user device, such as a smartphone, a tablet computer, a general purpose laptop computer or a dedicated measurement device or a dedicated monitor device. The user device may in particular be a user device capable of installing and executing programs thereon, such as a smartphone, a tablet computer or a general purpose laptop computer. The user device may thus be arranged to inform the user about the measurement value of the at least one electrical parameter or an indicator derived thereof by executing a suitably designed program that is installed on the user device capable of installing and executing programs thereon. E.g., the user device may be arranged to execute a so-called "app" arranged to execute instructions for causing the user device to inform the user about the measurement value of the at least one electrical parameter or an indicator derived thereof.

A fifth aspect not forming part of the claimed invention provides a method of operating an electronic interface device according to embodiments of the first aspect so as to let the electronic interface device at least obtain a measurement value of at least one electrical parameter indicative of a performance of the lamp of the auxiliary lighting system during at least part of the driven state, and to transmit a signal indicative of the measurement value of the at least one electrical parameter over a wireless channel to a user device to allow the user device to inform a user of the measurement value of the at least one electrical parameter or an indicator derived thereof.

A sixth aspect not forming part of the claimed invention provides a method of informing a user, the method comprising receiving the signal indicative of the measurement value of at least one electrical parameter indicative of a performance of a lamp of an auxiliary lighting system during at least part of a driven state wherein the lamp of the auxiliary lighting system is operated in correspondence with a corresponding lamp of the vehicle lighting system, deriving an indicator of the measurement value of the at least one electrical parameter from processing the signal as received, and informing a user of the indicator.

A seventh aspect according to the invention provides a test system comprising an electronic interface device according to any one embodiment of the first aspect and a user device according to any one embodiment of the fourth aspect and a measurement module according to the ninth aspect.

The test system may further comprise a user interaction device, such as a desk top computer, arranged to receive test results from the user device and/or the measurement module via a wireless communication network and to visually provide information to a user of the interaction device by means of a display.

An eighth aspect not forming part of the claimed invention provides a method of testing comprising a method of operating an electronic interface device according to any one embodiment of the fifth aspect so as to let as the electronic interface device at least obtain a measurement value of at least one electrical parameter indicative of a performance of the lamp of the auxiliary lighting system during at least part of the driven state and a method of informing a user according to any one embodiment of the sixth aspect.

A ninth aspect according to the invention provides a measurement module comprising a measurement circuit for obtaining a measurement value of a trailer lamp drive signal during at least part of a driven state and a wireless interface for transmitting a signal indicative of the measurement value of the at least one electrical parameter to a user device to allow the user device to inform a user of the measurement value of the at least one electrical parameter or an indicator derived thereof, the measurement module being connectable to the output terminal of an interface module according to any one embodiment of the first aspect to receive the trailer lamp drive signal from the selectively driven output terminal. Hereby, the measurement module may provide the user device with a measurement value of at least one electrical parameter indicative of a performance of the interface module and the semiconductor driving device therein during at least part of the driven state, whereby the user may be informed of the performance of the interface module.

A tenth aspect according to the invention provides a measurement box, the measurement box comprising a measurement module according to any one embodiment of the ninth aspect, a measurement cable and a measurement-side plug comprising one or more measurement terminals, the measurement module being connected via the measurement cable to the measurement terminals. The measurement-side plug may be arranged to be removably insertable in a tow bar socket for connecting to the output terminal of an interface module according to any one embodiment of the first aspect to receive the trailer lamp drive signal from the selectively driven output terminal. Hereby, the measurement box may provide the user device with a measurement value of at least one electrical parameter indicative of a performance of the interface module and the semiconductor driving device therein during at least part of the driven state, whereby the user may be informed of the performance of the interface module.

In a further aspect not forming part of the claimed invention, a computer program product is provided comprising instructions for causing a processor system to perform any one of the methods set forth.

Further embodiments advantages of the second, third, fourth, fifth, sixth, seventh, eighth, ninth, tenth and further aspects may be derived from the description given above for embodiments of the first aspect and/or any other of the second, third, fourth, fifth, sixth, seventh, eighth and further aspects.

It will be appreciated by those skilled in the art that two or more of the above-mentioned embodiments, implementations, and/or aspects of the disclosure may be combined in any way deemed useful.

Modifications and variations of the lighting system, the vehicle, the methods, and/or the computer program product which correspond to the described modifications and variations of the electronic interface device and other aspects, can be carried out by a person skilled in the art on the basis of the present description.

The invention is defined by the subject-matter of claim 1.

### BRIEF DESCRIPTION OF THE DRAWINGS

These and other aspects of the disclosure are apparent from and will be elucidated with reference to the embodiments described hereinafter. Elements in the figures are illustrated for simplicity and clarity and have not necessarily been drawn to scale. In the drawings,
Figure 1 schematically illustrates a lighting system comprising a vehicle lighting system, a trailer lighting system and an interface device according to an embodiment;
Figure 2 schematically illustrates an operation of the interface device and a user device according to an embodiment;
Figure 3 schematically illustrates an interface module according to an embodiment;
Figure 4 schematically illustrated a method as performed by an interface module according to different embodiments;
Figure 5 schematically illustrated a method as performed by a user device according to different embodiments;
Figure 6 schematically illustrates a testing of an interface device using a measurement device according to the invention and a user device according to an embodiment;
Figure 7 schematically illustrates a testing of a trailer lighting system using an interface device and a user device according to an embodiment;
Figure 8 schematically illustrates a method of manufacturing according to an embodiments; and
Figure 9 schematically illustrates an interface device according to an embodiment.

### DETAILED DESCRIPTION OF EMBODIMENTS

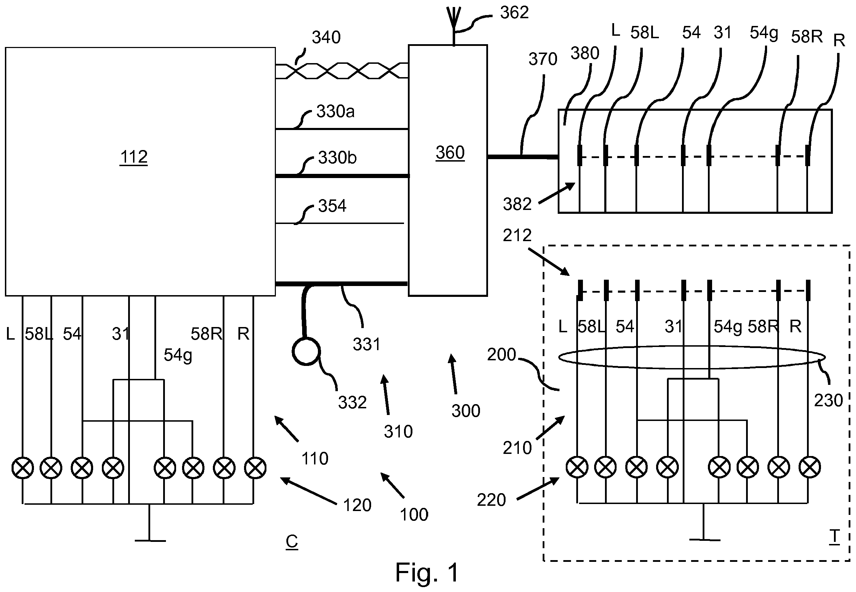

Figure 1 schematically illustrates a lighting system 100 comprising a vehicle lighting system 110 of a vehicle, a trailer lighting system 210 of a trailer and an interface device 300 for connecting the trailer lighting system 210 to the vehicle lighting system 110.

The vehicle lighting system 110 comprises a vehicle power and control system 112 connected to a battery (not shown), to a plurality of vehicle lamps 120 with respective vehicle lamp switched power lines L, 58L, 54, 54g, 58R and R, and to a vehicles common with ground line 31. Herein, the vehicle lamp switched power lines L, 58L, 54, 54g, 58R and R and ground line 31 are indicated with commonly used reference symbols, wherein L indicates a left indicator light, 58L indicates a left rear light, 54 indicates a brake light, 54g indicates a fog light, 58R indicates a right rear light, R indicates a right indicator light and 31 indicates a ground line. The vehicle power and control system 112 comprises, in the example shown, a CAN-bus for communicating control signals through the vehicle, including control signals for operating the lamps. However, other control signal means may be provided alternatively or additionally. For example, the vehicle switched power line 54, corresponding to the operation of the brake light, may directly controlled from the brake pedal.

The trailer lighting system 210 has a plurality of trailer lamps 220 which are connected with trailer lamp power lines L, 58L, 54, 54g, 58R and R and a trailer common line 31 to respective trailer terminals 212. It is remarked that the same reference numbers are used for the trailer lamp power lines as for the vehicle, as this is common practice in the field of trailer lighting. Where a specific reference to a trailer lamp power line is meant, an additional "_T" may be added to the reference symbols, e.g. L_T indicating the left indicator light of the trailer. The trailer terminals 212 are arranged in a plug, in this example a 7-pole plug according to the seven-pin trailer connection system ISO 1724. The trailer lamp power lines L, 58L, 54, 54g, 58R and R may first be routed together through a trailer cable 230 which may extend a distance from the plug in a tow bar socket 380 provided at the vehicle to the trailer side T, before being routed inside the trailer to the respective trailer lamps 220. The plug may alternatively be, for example, a 13-pin connector according to the thirteen-pin trailer connection system DIN 11446:2004, allowing to also control, e.g., reversing lights and to supple a steady power supply as well as a power supply controlled by the car's ignition switch.

The interface device 300 is installed in the vehicle. The interface device 300 has an input cable harness 310, an output cable harness 370 (which may also be referred to as a tow bar cable harness 370), and an interface module 360. The interface module 360 is connected to the vehicle lighting system 110 with the input cable harness 310. The input cable harness connects with a 12V - 15A supply line 330a, a 12V - 5A supply line 330b, a brake control line 354, a signal bus 340 and a ground line 331. The input cable harness 310 may have further and/or alternative lines in further and/or alternative embodiments. Also, voltages and/or currents on supply lines 330a, 330b may be different in further and/or alternative embodiments. The 12V - 15A supply line 330a and the 12V - 5A supply line 330b may together be referred to as supply line 330. The ground line is provided with an eye 332 for connecting the ground line to the vehicle's chassis. The output cable harness 370 connects the interface module 360 to a tow bar socket, in this example a 7-pole socket 380 according to the seven-pin trailer connection system ISO 1724. The 7-pole socket has seven pins 382, labeled as L, 58L, 54, 54g, 58R, R and 31, again using same reference numbers as for the vehicle power lines and trailer power lines in view of the common practice in the field of trailer lighting. The pins 382 of the 7-pole socket at vehicle side C are arranged to receive the corresponding trailer terminals 212 from the trailer side T. In the example given, the signal bus is a CAN-bus. In the example give, the brake control line 354 is directly taken from the vehicle switched power line 54 corresponding to the operation of the brake light.

As shown in Figure 1, the interface device 300 has an antenna 362 for wireless communication with other devices. The antennas 362 may for example be an antenna for radio transmission in a commonly used 2,4 GHz band, wireless communication according to wireless local area network (WLAN) computer communication in the 2.4, 3.6 and 5 GHz frequency bands (also known as WiFi) according to e.g., the IEEE 802.11a, 802.11b, 802.11g, 802.11n, 802.11ac and 802.11ag standards, short distance wireless communication (using short-wavelength radio transmissions in the so-called ISM band from 2400-2480 MHz) creating so-called personal area networks (PANs) with high levels of security such as using the Bluetooth standard as currently managed by the Bluetooth Special Interest Group, or so-called near-field communication (NFC) standards which based on existing radio-frequency identification (RFID) standards such as ISO/IEC 14443 and includes ISO/IEC 18092 and standards defined by the so-called NFC Forum. The antenna 362 may thus transmit information over a wireless channel 363 to, e.g., one or more user devices, e.g., a handheld device from a driver or an installer, or to a monitoring device, e.g., a computer or a specifically designed apparatus arranged to monitor a performance over a period of time.

The interface device 300 is arranged to obtain a measurement value of at least one electrical parameter indicative of a performance of the lamp of the auxiliary lighting system, in particular during at least part of a driven state. The interface device 300 is further arranged to transmit a signal indicative of the measurement value of the at least one electrical parameter to a user device to allow the user device to inform a user of the measurement value of the at least one electrical parameter or an indicator derived thereof.

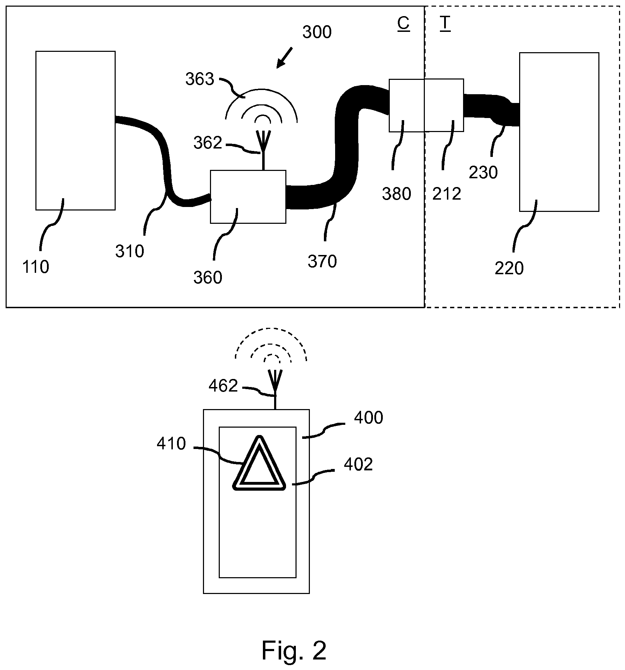

Figure 2 schematically illustrates a use of an interface device 300 according to embodiments. Figure 2 schematically shows an interface device 300 connected to a vehicle lighting system 110 of a vehicle. The interface device 300 has an input cable harness 310, an output cable harness 370 (which may also be referred to as a tow bar cable harness 370), and an interface module 360. The interface module 360 is connected to the vehicle lighting system 110 with the input cable harness 310. The interface module 360 is connected to a tow bar socket 380 with the output cable harness 370. The interface device 300 has an antenna 362 for wireless communication with other devices. The antenna 362 is arranged to transmit and receive information via a wireless channel 363 to and from, e.g., one or more user devices. One such user device is, in this non-limiting example, schematically shown to be a handheld user device 400.

A trailer having a plurality of trailer lamps 220 may be connected via a trailer cable 230 to the trailer terminals 212 arranged in the plug that is, when the trailer is connected to the vehicle lighting system, inserted in the tow bar socket 380.

The handheld user device 400 has an antenna 462 capable to at least receive information via the wireless channel 363 from at least the interface device 300. The antenna 462 may further be capable to transmit information via the wireless channel 363 to at least the interface device 300 or other devices. The handheld user device 400 has a display 402. In the example shown, the display 402 is a touch display, allowing a user to view visual information presented on the display and to input user information by appropriate touch operation of the touch display and, where necessary, operation of further input keys on the handheld user device 400. The user device 400 may thus comprise a user device wireless interface for receiving the signal indicative of the measurement value of the at least one electrical parameter, a signal processor (not drawn) for processing the signal as received by the user device wireless interface and derive an indicator of the measurement value of the at least one electrical parameter and an indicator device 402 for informing a user of the indicator. The indicator device comprises a visual indicator device, such as an electronic display 402 and/or an indicator light. The indicator device may alternatively or additionally comprises an audible indicator device, such as a speaker arranged to provide a sound, a retrieved spoken word, a retrieved spoken message, a synthesized spoken word or a synthesized spoken message.

The user device may be a handheld user device 400 such as, for example, be a GSM telephone, a third generation wireless telephone, a later generation wireless telephone, a so-called smartphone, a so-called tablet or pad, a netbook computer, a laptop computer, a handheld monitor device, or any other suitable handheld device. The user device may be a non-handheld device, such as a personal computer, a monitoring device, an industrial inspection device, any user interaction system or any intermediate system.

When the interface device 300 transmits a signal indicative of the measurement value of the at least one electrical parameter, the handheld user device 400 is arranged to receive the signal and, optionally after a decision scheme, to inform a user of the measurement value of the at least one electrical parameter or an indicator derived thereof. The handheld user device 400 may, for example, run a so-called app arranged to process the signal, compare with one or more reference values to classify the measurement value of the at least one electrical parameter into a selected class of a plurality of classes (e.g., into "OK" or "not OK"), and present for example a correspondingly selected icon 410 in dependence on the selected class. The icon 410 may e.g. comprise a warning sign where the selected class corresponds to a "not OK".

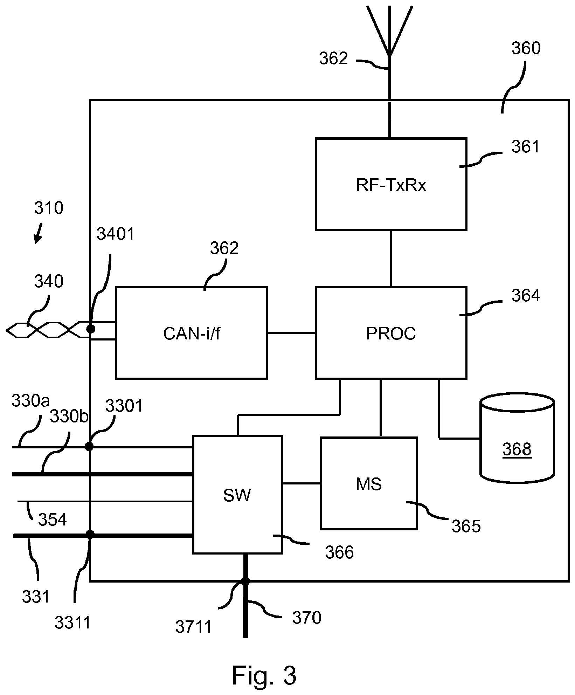

Figure 3 schematically illustrates an interface device 360 according to an embodiment. The interface device 360 comprises an antenna 362 and a RF transceiver 361, a processor 364 which may be a programmable processor such as a microprocessor, a CAN-bus interface 362, a plurality 366 of semiconductor driving devices, a measurement circuit 365, a memory 368, a control terminal 3401, an input power terminal 3301, an output power terminal 3711 and a reference power terminal 3311. The antenna 362 and the RF transceiver 361 may together be referred to as a wireless interface. The output power terminal 3711 is arranged to be electrical connected to the auxiliary lighting system via a tow bar cable 370. The control terminal 3401 is arranged to be electrically connected to the vehicle lighting system via a signal bus 340 for receiving a control signal from the signal bus 340. In this example, the signal bus 340 is a CAN-bus. The signal bus 340 may, in other embodiments, be, for example, a local area network or another in-vehicle bus or on-vehicle network. The input power terminal 3301 is arranged to be connected via a supply line 330 to the in-vehicle supply, such as the in-vehicle battery system. The input power terminal 3301 may comprise a first and a second sub-terminal for connecting to respectively a 12V - 15A supply line 330a and a 12V - 5A supply line 330b. The reference power terminal 3311 is arranged to be connected via a ground line 331 to an in-vehicle reference voltage, such as the in-vehicle ground line. The interface module 360 may thus be connected to the vehicle lighting system 110 with an input cable harness 310 comprising the supply line 300 (here, comprising a 12V - 15A supply line 330a and a 12V - 5A supply line 330b), a brake control line 354, the signal bus 340 and the ground line 331. The interface device 360 may, when connected to the in-vehicle supply, get its power from the input power terminal 3301 and reference power terminal 3311, to supply the plurality 366 of semiconductor driving devices, the processor 364, the CAN-bus interface 362, the RF transceiver 361, and the measurement circuit 365.

The semiconductor driving devices 366 are electrically connected to the control terminal via the processor 364 and the CAN-bus interface 362. Hereby, the semiconductor driving devices 366 may be controlled to selectively drive the output power terminal with a trailer lamp drive signal in dependence on the control signal. The interface module 360 may comprise a plurality of semiconductor driving devices electrically connected to one or more control terminals of the interface module for selectively driving a corresponding plurality of output power terminal with corresponding trailer lamp drive signals in dependence on respective control signals. The processor 364 and the CAN-bus interface 362 may be arranged to cooperate to translate CAN-data obtained from the CAN-bus to trailer lamp functions. Herein, each lamp function may have a unique data-code that is built-up of an Identifier field (ID), Data Length Code field (DLC) and data with a length depending on a value specified in the DLC field. Every lamp function may be arranged to react only to its unique data-code code, while not reacting to any other data-code associated with another lamp function. For example, a trailer tail lamp function may be related to a control of both tail lamp sides 58, while further left and read parking lamp functions PL, PR may be separate for each tail lamp side. Likewise may a trailer backup lamp BU be controlled by its own code, may the trailer indicator left lamps L and indicator right lamps T each have a separate code, and may a trailer Fog lamp 54G be controlled by its own data. Brake lamps 54 may be controlled by its own data, and additionally or alternatively be controlled via a direct brake lamp connection (not drawn). The skilled person may appreciate that not all car brands and car types have a CAN bus possibility for their brake lamp function. The control signal may, for each of the semiconductor driving devices 366, be in a drive state selected from at least a driven state and a non-driven state, corresponding to energizing a lamp for lightening the lamp and non-energizing of a lamp for putting the lamp off. The driven state may also be referred to as the ON-state and the non-driven state may also be referred to as the OFF-state. The ON-state may correspond to a continuous supply of a fixed voltage or current, a continuous supply of an amplitude-modulated voltage or current or to a pulse-width modulated supply of current to, e.g., control the brightness of the associated trailer lamps.

The measurement circuit 365 is arranged to obtain a measurement value of at least one electrical parameter indicative of a performance of an associated lamp of the auxiliary lighting system, in particular during at least part of the driven state.

The processor 364 is arranged to control the semiconductor driving devices 366 in accordance with the control signal, to receive the measurement value from the measurement circuit 365, and to provide the measurement value or a performance indicator derived thereof to the wireless interface 361. The processor 364 may thus be arranged to receive the measurement value of at least one electrical parameter indicative of the performance of the lamp of the auxiliary lighting system during at least part of the driven state from the measurement circuit 365, process the measurement value into a performance indicator, and providing the performance indicator to the wireless interface 361, 362 for transmitting the performance indicator as part of the signal. The interface device 360 may thus provide separate status feedback for each lamp function via the wireless interface 361.

The processor 364 may further be arranged receive control bus interface programming information from the wireless interface 361, 362 and to configure the CAN-bus interface 362 in dependence on the control bus interface programming information.

The memory 368 is connected to the processor 364, allowing the processor 364 to store and retrieve the measurement value of at least one electrical parameter of successive measurement values in/from the memory and/or to store in and retrieve the performance indicator in/from the memory 368 as historical data. The processor 364 may be arranged to process the measurement value into a performance indicator using at least part of the historical data, for detecting and/or signaling deviations over time, such as ageing effects.

The CAN-bus interface 362 and/or the processor 364 may be externally programmable via, e.g., the wireless interface 361 from an external programming apparatus arranged to communicate over a wireless channel with the CAN-bus interface 362 and/or the processor 364. The interface device 360 may thus be suitable for different types of CAN bus vehicles.

The CAN-bus interface 362 and the processor 364 may be integrated into a single semiconductor device. The CAN-bus interface 362 may be a functional part of the processor 364.

The wireless interface 361 is arranged to establish a signal indicative of the measurement value of the at least one electrical parameter from the measurement value or the performance indicator thereof as received from the processor 364, and to transmit the signal via antenna 362 over a wireless channel 363 to a user device 400 to allow the user device 400 to inform a user of the measurement value of the at least one electrical parameter or an indicator derived thereof.

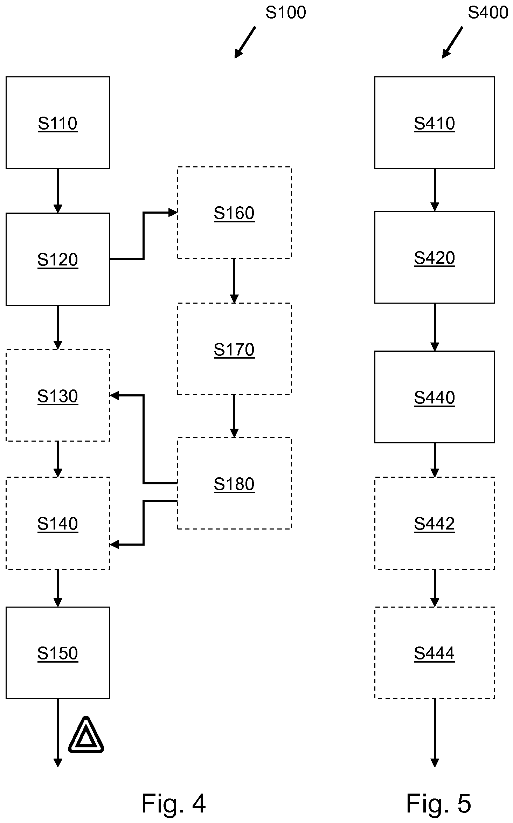

Figure 4 schematically illustrated a method S100 as performed by an interface module according to different embodiments.

The method S100 comprises driving S110 the semiconductor driving devices 366 in dependence on the control signal, measuring S120 at least one electrical parameter indicative of a performance of the lamp of the auxiliary lighting system during at least part of the driven state to obtain a measurement value of the at least one electrical parameter, and transmitting S150 a signal indicative of the measurement value of the at least one electrical parameter over a wireless channel to a user device to allow the user device to inform a user of the measurement value of the at least one electrical parameter or an indicator derived thereof.

Embodiments of the method comprise storing S160 the measurement value of at least one electrical parameter of successive measurement values and/or performance indicators (described below) obtained from successive measurement values in the memory as historical data. The embodiments may further comprise retrieving S170 the measurement value of at least one electrical parameter of successive measurement values and/or the performance indicators obtained from successive measurement values from the memory. The method may further comprise processing S180 the measurement value of at least one electrical parameter of successive measurement values as retrieved from the memory as historical data into a performance indicator, e.g., a performance change indicator indicative of a performance change over time (e.g., indicative of ageing effects).

The method may comprise, as additional processing to the measurement value of the at least one parameters and/or to the performance indicators, additional stages, such as comparing S130 the measurement value or the performance indicator with a reference value to detect any deviations or for classification and/or diagnosing S140 the lamp from analyzing the measurement value, the performance indicator and/or the associated deviations from corresponding reference values to establish a diagnosis. For example, where the measurement value indicates that no current is drawn, the diagnoses may be that a trailer lamp is not connected or broken. As another example, where the measurement value indicates current drawn has gradually decreased over time for a LED-based trailer lamp, the diagnosis may be that the LEDs have aged and a higher drive current may be required to compensate for the associated reduction in light output. As another example, where the measurement value indicates current drawn has suddenly decreased to about half for a LED-based trailer lamp comprising two LED string, the diagnosis may be that one of the LED strings is broken, possibly requiring a replacement. As again another example, where measurement values of all lamps correspond to a missing connection, the diagnosis could be that the trailer is not connected. Where the method performs a diagnosis, the signal indicative of the measurement value of the at least one electrical parameter may comprise the diagnosis.

Figure 5 schematically illustrated a method S400 as performed by a user device 400 according to different embodiments.

The method S400 comprises receiving S410 the signal indicative of the measurement value of at least one electrical parameter indicative of a performance of a lamp of an auxiliary lighting system during at least part of a driven state wherein the lamp of the auxiliary lighting system is operated in correspondence with a corresponding lamp of the vehicle lighting system. The method further comprises deriving S420 an indicator of the measurement value of the at least one electrical parameter from processing the signal as received and informing S440 a user of the indicator.

Informing S440 may comprise presenting a visual indicator on a visual indicator device, such as an electronic display and/or an indicator light. The visual indicator may e.g. be an icon such as a warning sign 410, a traffic sign symbol, a text message, or a graphical indication on a display. The visual indicator may additionally or alternatively comprise one or more indicator lights, such as a red indicator light for indicating a malfunction or disconnection of one or more trailer lamps, and a green indicator light for indicating an error free situation.

Informing S440 may comprise operating an a audible indicator device, such as a speaker, to provide an audible signal, such as a sound (e.g., a beep), a retrieved spoken word, a retrieved spoken message, a synthesized spoken word or a synthesized spoken message.

The method S400 may further comprise escalating S442 using an escalation message of another type or via another channel, such as sending a short message service (SMS) message to the user device or to another device, sending a message via a wireless internet connection, or, when the user device 400 is connected via a cable to a network, via a wired network, such as directly onto the internet.

The method S400 may further comprise alerting S444 a third party, such as an emergency service, a rescue service or a road side assistance service with an alert message , e.g. where the indicator corresponds to a loss of the trailer, a sudden break-down of one or more trailer lamps or another situation requiring attention from a third party.

Escalating S442 or alerting S444 may comprise detecting a position of the user device as a representative position of the vehicle, obtaining an indication of the position (such as GPS coordinates), and including the indication of the position in the escalation message or the alert message.

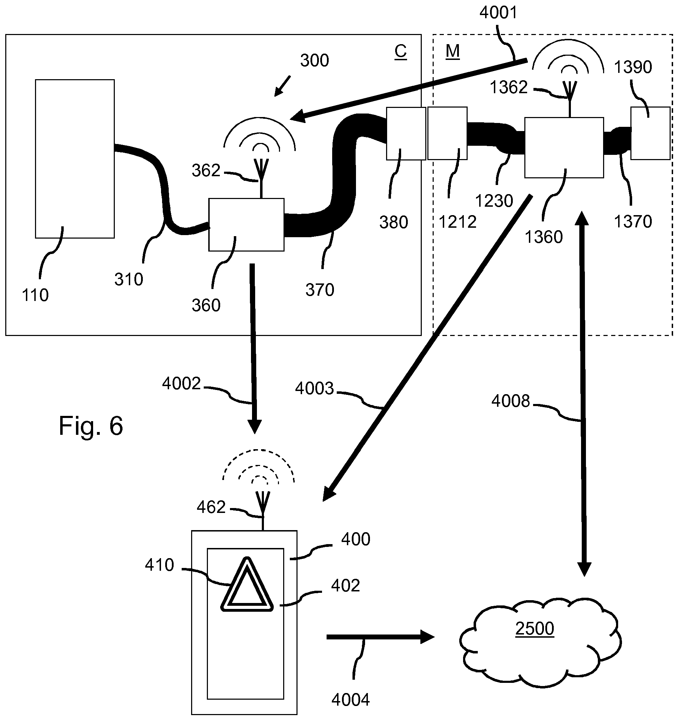

Figure 6 schematically illustrates a testing of an interface device 360 using a measurement module 1360 and a user device 400 according to the invention.

Figure 6 schematically shows an interface device 300 connected to a vehicle lighting system 110 of a vehicle C in a similar manner as described with reference to Figure 2.

Similar as in Figure 2, the interface device 300 has an input cable harness 310, an output cable harness 370 (which may also be referred to as a tow bar cable harness 370), and an interface module 360. The interface module 360 is connected to the vehicle lighting system 110 with the input cable harness 310. The interface module 360 is connected to a tow bar socket 380 with the output cable harness 370. The interface device 300 has an antenna 362 for wireless communication with other devices. The antenna 362 is arranged to transmit and receive information via a wireless channel to and from, e.g., one or more user devices. One such user device is, in this non-limiting example, schematically shown to be a handheld user device 400. The interface module 360 comprises, as described above a semiconductor driving device electrically connected to a control terminal of the interface module for selectively driving the output power terminal with a trailer lamp drive signal in dependence on a control signal. The trailer lamp drive signal is arranged to be suitable for operating a lamp of an auxiliary lighting system corresponding to the lamp of the vehicle lighting system. The control signal may be in a drive state selected from at least a driven state and a non-driven state.

The interface module 360 may comprise a plurality of semiconductor driving devices electrically connected to one or more control terminals of the interface module for selectively driving a corresponding plurality of output power terminals with corresponding trailer lamp drive signals in dependence on respective control signals.

A measurement box M is arranged to be connected to the tow bar socket 380. Hereto, the measurement box M comprises a measurement module 1360 connected via a measurement cable 1230 to measurement terminals 1212, which are arranged in a measurement-side plug. The measurement module 1360 is connected via an output cable 1370 to a test lighting unit 1390. The test lighting unit 1390 may comprise a plurality of lamps (not shown) which may be considered to take the place of the lamps of a trailer system. The measurement-side plug is, when the measurement box M is connected to the vehicle lighting system, inserted in the tow bar socket 380. The measurement box M may be considered to take the place of the trailer T of Figure 2, where the measurement module 1360 takes the place of the trailer lighting systems and the trailer lamps, the measurement cable 1230 takes the place the trailer cable 230, and the measurement terminals 1212 take the place of the trailer terminals 212. The measurement module 1360 is connected to the interface module 360 to receive the trailer lamp drive signals. The measurement box M may hereby simulate a trailer with a trailer lighting system, while being equipped to measure the trailer lamp drive signal(s).

The measurement module 1360 comprises at least part of the components and functionality of the interface module described with reference to Figure 2. The measurement module 1360 may, e.g., comprise an interface module according to an embodiment. The measurement module 1360 comprises at least a measurement circuit for obtaining a measurement value of the trailer lamp drive signal(s) during at least part of the driven state and a wireless interface for transmitting a signal indicative of the measurement value of the at least one electrical parameter to a user device to allow the user device to inform a user of the measurement value of the at least one electrical parameter or an indicator derived thereof. The measurement module 1360 hereby comprises at least a measurement circuit for obtaining a measurement value of at least one electrical parameter indicative of a performance of the interface module 360 and the semiconductor driving device therein, during at least part of the driven state.

The measurement module 1360 has a module antenna 1362 for wireless communication with other devices. The module antenna 1362 is arranged to transmit and receive information via a wireless channel to and from, e.g., one or more user devices such as handheld device 400, and, optionally, to and/or from the interface device 300.

The handheld user device 400 has an antenna 462 capable to at least receive information from at least the interface device 300 and the measurement module 1360. The antenna 462 may further be capable to transmit information via the wireless channel 363 to the interface device 300 and/or the measurement module 1360. The handheld user device 400 has a display 402. In the example shown, the display 402 is a touch display, allowing a user to view visual information presented on the display and to input user information by appropriate touch operation of the touch display and, where necessary, operation of further input keys on the handheld user device 400. The user device 400 may thus comprise a user device wireless interface for receiving a first signal indicative of the measurement value of the at least one electrical parameter of the trailer lamp drive signal as generated by the interface module 360 and measured by the measurement circuit inside the interface module 360 as well as a second signal indicative of the measurement value of the trailer lamp drive signal as measured by the measurement circuit inside the measurement module 1360. The user device 400 may further comprise a signal processor (not drawn) for processing the first and the second signal as received by the user device wireless interface to check the performance of the interface device 360 after it is installed in the vehicle and connected to the vehicle lighting system. The processing may comprise analyzing the trailer lamp drive signal as measured by the measurement circuit inside the measurement module 1360, e.g. by correlating it with the trailer lamp drive signal as measured by the measurement circuit inside the interface module 360, or by correlating it with the control signal. The processing may comprise deriving an indicator of the performance of the interface module 360. The processor may further be arranged to present the indicator on an indicator device 402 for informing a user of the indicator. The indicator device comprises a visual indicator device, such as an electronic display 402 and/or an indicator light. The indicator device may alternatively or additionally comprises an audible indicator device, such as a speaker arranged to provide a sound, a retrieved spoken word, a retrieved spoken message, a synthesized spoken word or a synthesized spoken message.

The measurement box M may thus be used by an installer of the electronic interface device 300 or a car dealer to check whether the interface device 360 is correctly installed and performing well. The measurement box M may further be used by a car repair man, a driver or any other person to check and diagnose any possible malfunction of the electronic interface device 300.

The measurement module 1360 may comprise a processor arranged to send test control signals via the wireless interface 1362 to an electronic interface device, such as the electronic interface device 300 installed in the vehicle C to perform a test procedure. The test procedure may involve the steps of:
- creating test control signals by the processor of the measurement module 1360;
- sending the test control signals via a wireless communication channel to the electronic interface device 300, see arrow 4001;
- receiving by the user device 400 a first signal indicative of the measurement value, see arrow of the at least one electrical parameter of the trailer lamp drive signal as generated by the interface module 360 and measured by the measurement circuit inside the interface module 360;
- optionally receiving by the use device 400 a second signal indicative of the measurement value of the trailer lamp drive signal as measured by the measurement circuit inside the measurement module 1360;
- optionally send the first and/or second signal via a wireless communication network 2500 to a remote user interaction device (not shown in Figure 6).

The test procedure described above may be initiated by a car repair man operating the measurement box M. Alternatively, the test procedure may be initiated by a user of the mobile user device 400. It is also conceivable that the test procedure is initiated by a user of a remote user interaction device, such as a desktop computer, laptop etcetera, at a remote site (e.g. a help desk) communicating with the measurement box M via the wireless communication network 2500. Commands coming from such a remote user interaction device may be sent directly to the measurement box M, see arrow 4008, or via the mobile user device 400.

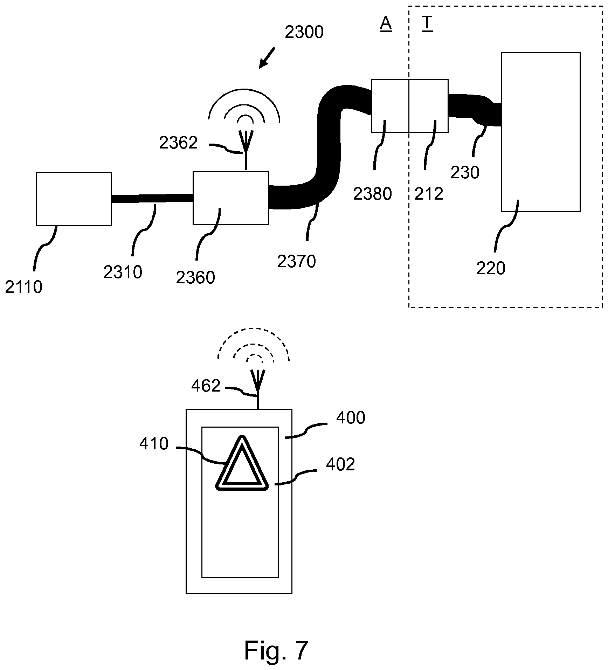

Figure 7 schematically illustrates a testing of a trailer lighting system using an interface device and a user device according to an embodiment.

Figure 7 shows a trailer having a trailer lighting system comprising a plurality of trailer lamps 220 connected via a trailer cable 230 to trailer terminals 212 arranged in a trailer plug, The trailer plug is suitable for connecting the trailer lighting system to a vehicle lighting system, by inserting the trailer plug in a tow bar socket 380 as shown in Figure 2.

In Figure 7, the trailer plug is not connected in a tow bar socket 380 of a vehicle, but instead it is inserted in a corresponding tow bar socket of a trailer lighting analyze system A.

The trailer lighting analyze system A comprises a power supply 2110 arranged to provide a 12V - 15A supply, a 12V - 5A supply and a reference ground to simulate a vehicles power supply circuit. The power supply 2110 is connected to an interface device 2300 of an interface module 2360 with power lines 2310 (similar to an input cable harness 310) to supply the interface module 2360 with a 12V - 15A supply, a 12V - 5A supply and a reference ground. The interface module 2360 is connected to a tow bar socket 2380 with an output cable harness 2370, similar to output cable harness 370. Tow bar socket 2380 and output cable harness 2370 may be the same as tow bar socket 380 and output cable harness 370. The interface device 2300 has an antenna 2362 for wireless communication with other devices. Antenna 2362 is arranged to transmit and receive information via a wireless channel to and from, e.g., one or more user devices. One such user device is, in this non-limiting example, schematically shown to be a handheld user device 400. The user device 400 of Figure 7 may be arranged to receive and transmit information via the wireless channel. The user device 400 may e.g. execute a program arranged to accept user input, to provide user control signals in dependence on the user input and to transmit the user control signals to the interface module 2360.

The interface module 2360 may substantially correspond to interface module 360 described above. The interface module 2360 may thus comprise a plurality of semiconductor driving devices electrically connected to one or more control terminals of the interface module for selectively driving a corresponding plurality of output power terminals with corresponding trailer lamp drive signals in dependence on respective control signals. The control signals may be generated by the processor in the interface module 2360, for example in response of user control signals provided by a user via the user device 400 over the wireless channel. The control signals may alternatively be provided from a control generation unit via a CAN-bus connected to the interface module 2360. The interface module 2360 may further comprise a measurement circuit equal or similar to measurement circuit 365, arranged to obtain a measurement value of at least one electrical parameter indicative of a performance of an associated lamp of the auxiliary lighting system, in particular during at least part of the driven state. The interface module 2360 may further comprise a processor equal or similar to processor 364 and arranged to control the semiconductor driving devices of interface module 2360 in accordance with the control signal, to receive the measurement value from the measurement circuit of interface module 2360, and to provide the measurement value or a performance indicator derived thereof to a wireless interface of interface module 2360 equal to or similar to wireless interface 361. The processor may thus be arranged to receive the measurement value of at least one electrical parameter indicative of the performance of the lamp of the auxiliary lighting system during at least part of the driven state from the measurement circuit, process the measurement value into a performance indicator, and providing the performance indicator to the wireless interface for transmitting the performance indicator as part of the signal via antenna 2362. Interface device 2360 may thus provide separate status feedback to the user device 400 for each lamp function via its wireless interface.

The trailer lighting analyze system A may thus be used to selectively drive a corresponding plurality of output power terminals with corresponding trailer lamp drive signals in dependence on respective control signal. The trailer lighting analyze system A thus provides a setup to test connections from the trailer plug to the trailer lamps of the trailer, without requiring the presence of a vehicle to perform the test.

User interaction system may be a user device, such as a handheld user device 400 as shown in Figure 2, Figure 6 and Figure 7. The user interaction system may alternatively comprise multiple devices.

User device 400 can be a wireless phone, smartphone, tablet, laptop, personal computer, or any other programmable apparatus capable of executing a computer program product comprises instructions to let the user device receive information over a wireless channel from the interface module 360 of the interface device 300, process said information, and inform a user of the user device 400 in dependence on the information.

The user device 400 may, for example, be a smartphone operated using an Android operation system and the computer program product may correspond to an appropriately programmed app.

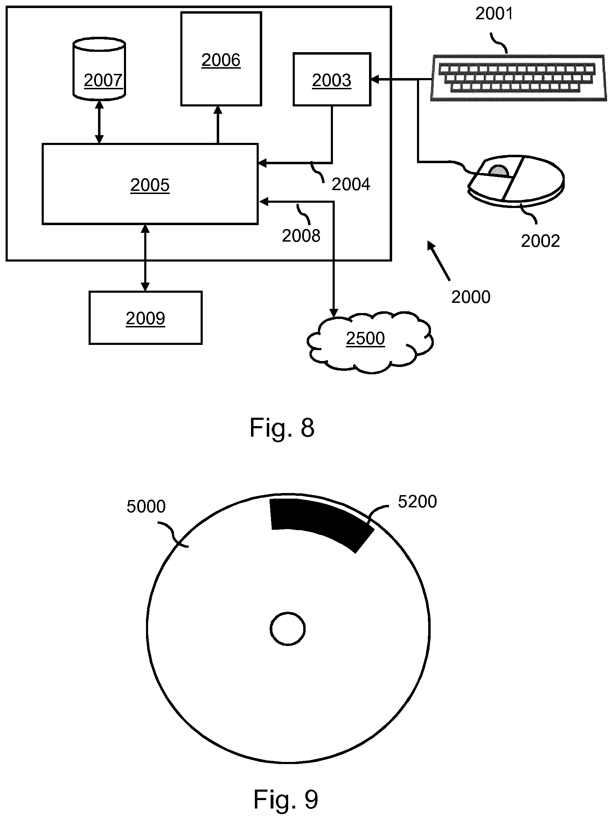

Figure 8 schematically shows another exemplary user interaction system 2000 having a programmable processor 2005. The user interaction system 2000 is shown to be a personal computer, but may be any type of suitable user interaction system 2000. The user interaction system 2000 further comprises a storage unit 2007, a user input 2003 and a display 2006, which may be the same as display 402 of user device 400 or another display. The user input 2003 allows the user to input user data and user instructions 2004 to the processor 2005 by e.g. using a keyboard 2001 or a mouse 2002. Also, although not shown, the display 2006 may comprise a touch-sensitive surface for enabling the user to provide user data and user instructions to the user input 2003 by means of touching the display 2006. The processor 2005 is arranged to perform any one of the methods according to the disclosure, to receive user data and user instructions 2004, to present visual information on the display 2006 and to communicate with a data I/O device 2009, such as an optical disc drive or a solid state reader/writer. The processor 2005 is arranged to cooperate with the storage unit 2007, allowing storing and retrieving information on the storage unit 2007, such as information received over the wireless channel from the interface module 360. The user interaction system 2000 may further comprise a further communication channel 2008 allowing the processor 2005 to connect to an external cloud 2500 for communicating with other devices in the cloud. The external cloud may e.g. be the Internet. The user interaction system 2000 may allow inspection by a user of any information stored on the storage unit and/or any information received over the wireless channel from the interface module 360. The user interaction system 2000 may allow a user to input test conditions for letting the user interaction system send the test conditions to, for example, the interface module 360 to perform further tests or repeated tests of a certain trailer lamp. The processor 2005 may also be arranged to retrieve information received or determined during executions of the method from the storage unit 2007 or from another device in the cloud 2500, and to generate a report by the processor 2005. The processor 2005 may be capable to read, using the data I/O device 2009, a computer readable medium comprising a program code. The processor 2005 may be capable to read, using the data I/O device 2007, a computer readable medium comprising a computer program product comprising instructions for causing the user interaction system 2000 to perform a method as described with reference to Figure 5, any part of said method, or any further embodiments of said method. The method may further generate a report of the results obtained. The report may be reported to the user as visual information on the display and/or written to a log file and/or displayed on the display.

Figure 9 shows a computer readable medium 5000 comprising a computer program 5200, the computer program 5200 comprising instructions for causing a processor system to perform a method according to an embodiment, any part of said method, or any further embodiments of said method. The method may be, or comprise, a method as described with reference to Figure 4 when the computer program is intended to be loaded into interface module 360. The method may be, or comprise, a method as described with reference to Figure 5 when the computer program is intended to be loaded on user device 400 or a user interaction system 2000,. The computer program 5200 may be embodied on the computer readable medium 5000 as physical marks or by means of magnetization of the computer readable medium 5000. However, any other suitable embodiment is conceivable as well. Furthermore, it will be appreciated that, although the computer readable medium 5000 is shown in Figure 9 as an optical disc, the computer readable medium 5000 may be any suitable computer readable medium, such as a hard disk, solid state memory, flash memory, etc., and may be non-recordable or recordable.

It will be appreciated that the disclosure also applies to computer programs, particularly computer programs on or in a carrier, adapted to put the disclosure into practice. The program may be in the form of a source code, an object code, a code intermediate source and an object code such as in a partially compiled form, or in any other form suitable for use in the implementation of the method according to the disclosure. It will also be appreciated that such a program may have many different architectural designs. For example, a program code implementing the functionality of the method or system according to the disclosure may be sub-divided into one or more sub-routines. Many different ways of distributing the functionality among these sub-routines will be apparent to the skilled person. The sub-routines may be stored together in one executable file to form a self-contained program. Such an executable file may comprise computer-executable instructions, for example, processor instructions and/or interpreter instructions (e.g. Java interpreter instructions). Alternatively, one or more or all of the sub-routines may be stored in at least one external library file and linked with a main program either statically or dynamically, e.g. at run-time. The main program contains at least one call to at least one of the sub-routines. The sub-routines may also comprise function calls to each other. An embodiment relating to a computer program product comprises computer-executable instructions corresponding to each processing step of at least one of the methods set forth herein. These instructions may be sub-divided into sub-routines and/or stored in one or more files that may be linked statically or dynamically. Another embodiment relating to a computer program product comprises computer-executable instructions corresponding to each means of at least one of the systems and/or products set forth herein. These instructions may be sub-divided into sub-routines and/or stored in one or more files that may be linked statically or dynamically.

The carrier of a computer program may be any entity or device capable of carrying the program. For example, the carrier may include a storage medium, such as a ROM, for example, a CD ROM or a semiconductor ROM, or a magnetic recording medium, for example, a hard disk. Furthermore, the carrier may be a transmissible carrier such as an electric or optical signal, which may be conveyed via electric or optical cable or by radio or other means. When the program is embodied in such a signal, the carrier may be constituted by such a cable or other device or means. Alternatively, the carrier may be an integrated circuit in which the program is embedded, the integrated circuit being adapted to perform, or used in the performance of, the relevant method.

It should be noted that the above-mentioned embodiments illustrate rather than limit the invention, which is defined by the features of claim 1, and that those skilled in the art will be able to design many alternative embodiments without departing from the scope of the appended claims. In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

## Claims

1. A measurement module (1360) comprising a measurement circuit for obtaining a measurement value of a trailer lamp drive signal during at least part of a driven state and a wireless interface for transmitting a signal indicative of the measurement value of at least one electrical parameter of the trailer lamp drive signal to a user device to allow the user device to inform a user of the measurement value of the at least one electrical parameter or an indicator derived thereof,
- the measurement module (1360) being connectable to an output terminal (3711) of an interface module (360) to receive the trailer lamp drive signal from the selectively driven output terminal,
- the interface module (360) being comprised an interface device (300) for connecting an auxiliary lighting system to a vehicle lighting system of a vehicle and driving the auxiliary lighting system from the vehicle lighting system, the interface module comprising:
- the output power terminal (3711) for electrically connecting to the auxiliary lighting system via a tow bar cable,
- a control terminal (3401) for electrically connecting to the vehicle lighting system for receiving a control signal corresponding to an operation of a lamp of the vehicle lighting system,
- a semiconductor driving device (366) electrically connected to the control terminal for selectively driving the output power terminal in dependence on the control signal for operating a lamp of the auxiliary lighting system corresponding to the lamp of the vehicle lighting system, the control signal being in a drive state selected from at least a driven state and a non-driven state,
- a measurement circuit (365) for obtaining a measurement value of at least one electrical parameter indicative of a performance of the lamp of the auxiliary lighting system during at least part of the driven state,
- a wireless interface (361, 362) for communication with a remote user device (400) external from the vehicle and the auxiliary lighting system, and
- a processor (364) arranged for sending, via the wireless interface, a signal indicative of the measurement value of the at least one electrical parameter to the user device to allow the user device to inform a user of the measurement value of the at least one electrical parameter or an indicator derived thereof.

2. A measurement module according to claim 1, the measurement module further comprising a processor arranged to send test control signals via the wireless interface (1362) to said interface module to perform a test procedure.

3. A measurement box, the measurement box (M) comprising a measurement module (1360) according to any one of claims 1 - 2, a measurement cable (1230) and a measurement-side plug comprising one or more measurement terminals (1212), the measurement module being connected via the measurement cable to the measurement terminals, the measurement-side plug being insertable in a tow bar socket (380).

4. A test system comprising an electronic interface module (360), a user device (400), and a measurement module (1360)
- the interface module (360) being comprised an interface device (300) for connecting an auxiliary lighting system to a vehicle lighting system of a vehicle and driving the auxiliary lighting system from the vehicle lighting system, the interface module comprising:
- an output power terminal (3711) for electrically connecting to the auxiliary lighting system via a tow bar cable,
- a control terminal (3401) for electrically connecting to the vehicle lighting system for receiving a control signal corresponding to an operation of a lamp of the vehicle lighting system,
- a semiconductor driving device (366) electrically connected to the control terminal for selectively driving the output power terminal in dependence on the control signal for operating a lamp of the auxiliary lighting system corresponding to the lamp of the vehicle lighting system, the control signal being in in a drive state selected from at least a driven state and a non-driven state,
- a measurement circuit (365) for obtaining a measurement value of at least one electrical parameter indicative of a performance of the lamp of the auxiliary lighting system during at least part of the driven state,
- a wireless interface (361,362) for communication with a remote user device (400) external from the vehicle and the auxiliary lighting system, and
- a processor (364) arranged for sending, via the wireless interface, a signal indicative of the measurement value of the at least one electrical parameter to the user device to allow the user device to inform a user of the measurement value of the at least one electrical parameter or an indicator derived thereof;
- the user device (400) comprising:
- a user device wireless interface for receiving the signal indicative of the measurement value of the at least one electrical parameter from such type of an interface module (360), a measurement module (1360) according to any one of the preceding claims, or a vehicle (C) comprising a vehicle lighting system (110) and such interface module (360), the interface module being arranged to connect an auxiliary lighting system (210), such as a trailer lighting system, to the vehicle lighting system of the vehicle and to, when connected, drive the auxiliary lighting system from the vehicle lighting system;
- a signal processor arranged to process the signal as received by the user device wireless interface and to derive an indicator of the measurement value of the at least one electrical parameter; and
- an indicator device arranged to inform a user of the indicator, wherein the indicator device optionally comprises at least one of:
- a visual indicator device, such as an electronic display and/or an indicator light, and
- an audible indicator device, such as a speaker arranged to provide a sound, a retrieved spoken word, a retrieved spoken message, a synthesized spoken word or a synthesized spoken message,
wherein the signal processor is optionally arranged to store the measurement value in a local memory of the user device and/or forward the measurement value to a remote user interaction device (2000) via a wireless communication network (2500);
and
- the measurement module (1360) being a measurement module according to any one of claims 1 - 2.

5. A test system according to claim 4, further comprising a user interaction device (2000) arranged to receive test results from the user device (400) and/or the measurement module (1360) via a wireless communication network (2500) and to visually provide information to a user of the user interaction device (2000) by means of a display (2006).

## Patentansprüche

1. Ein Messmodul (1360), umfassend eine Messschaltung zum Erhalten eines Messwerts eines Anhängerlampenantriebssignals während mindestens eines Teils eines angetriebenen Zustands und eine drahtlose Schnittstelle zum Übertragen eines Signals, das den Messwert mindestens eines elektrischen Parameters des Anhängerlampenantriebssignals an eine Benutzervorrichtung überträgt, um der Benutzervorrichtung zu ermöglichen, einen Benutzer über den Messwert des mindestens einen elektrischen Parameters oder einen davon abgeleiteten Indikator zu informieren,
- wobei das Messmodul (1360) mit einem Ausgangsanschluss (3711) eines Schnittstellenmoduls (360) verbunden werden kann, um das Anhängerlampenantriebssignal von dem selektiv angetriebenen Ausgangsanschluss zu empfangen,
- wobei das Schnittstellenmodul (360) in einer Schnittstellenvorrichtung (300) zum Verbinden eines Hilfsbeleuchtungssystems mit einem Fahrzeugbeleuchtungssystem eines Fahrzeugs und Antreiben des Hilfsbeleuchtungssystems von dem Fahrzeugbeleuchtungssystem umfasst ist, wobei das Schnittstellenmodul umfasst:
- den Energieausgangsanschluss (3711) zum elektrischen Verbinden mit dem Hilfsbeleuchtungssystem über ein Zughakenkabel,
- einen Steueranschluss (3401) zum elektrischen Verbinden mit dem Fahrzeugbeleuchtungssystem zum Empfangen eines Steuersignals, das einem Betrieb einer Lampe des Fahrzeugbeleuchtungssystems entspricht,
- eine Halbleiterantriebsvorrichtung (366), die mit dem Steueranschluss elektrisch verbunden ist, um den Energieausgangsanschluss in Abhängigkeit vom Steuersignal zum Betreiben einer Lampe des Hilfsbeleuchtungssystems, die der Lampe des Fahrzeugbeleuchtungssystems entspricht, selektiv anzutreiben, wobei das Steuersignal in einem Antriebszustand ist, der aus mindestens einem angetriebenen und einem nicht angetriebenen Zustand ausgewählt ist,
- eine Messschaltung (365) zum Erhalten eines Messwerts mindestens eines elektrischen Parameters, der eine Leistung der Lampe des Hilfsbeleuchtungssystems während mindestens eines Teils des angetriebenen Zustands angibt,
- eine drahtlose Schnittstelle (361, 362) zur Kommunikation mit einer entfernten Benutzervorrichtung (400), die extern zu dem Fahrzeug und dem Hilfsbeleuchtungssystem ist, und
- einen Prozessor (364), der zum Senden, über die drahtlose Schnittstelle, eines Signals, das den Messwert des mindestens einen elektrischen Parameters angibt, an die Benutzervorrichtung eingerichtet ist, um der Benutzervorrichtung zu ermöglichen, einen Benutzer über den Messwert des mindestens einen elektrischen Parameters oder einen davon abgeleiteten Indikator zu informieren.

2. Ein Messmodul nach Anspruch 1, wobei das Messmodul weiter einen Prozessor umfasst, der eingerichtet ist, um Teststeuersignale über die drahtlose Schnittstelle (1362) an das Schnittstellenmodul zu senden, um eine Testprozedur durchzuführen.

3. Eine Messbox, wobei die Messbox (M) ein Messmodul (1360) nach einem der Ansprüche 1-2, ein Messkabel (1230) und einen messungsseitigen Stecker umfasst, der einen oder mehrere Messanschlüsse (1212) umfasst, wobei das Messmodul über das Messkabel mit dem Messanschluss verbunden ist, wobei der messungsseitige Stecker in eine Zughakenbuchse (380) eingeführt werden kann.

4. Ein Testsystem, umfassend ein elektronisches Schnittstellenmodul (360), eine Benutzervorrichtung (400) und ein Messmodul (1360)
- wobei das Schnittstellenmodul (360) in einer Schnittstellenvorrichtung (300) zum Verbinden eines Hilfsbeleuchtungssystems mit einem Fahrzeugbeleuchtungssystem eines Fahrzeugs und Antreiben des Hilfsbeleuchtungssystems von dem Fahrzeugbeleuchtungssystem umfasst ist, wobei das Schnittstellenmodul umfasst:
- einen Energieausgangsanschluss (3711) zum elektrischen Verbinden mit dem Hilfsbeleuchtungssystem über ein Zughakenkabel,
- einen Steueranschluss (3401) zum elektrischen Verbinden mit dem Fahrzeugbeleuchtungssystem zum Empfangen eines Steuersignals, das einem Betrieb einer Lampe des Fahrzeugbeleuchtungssystems entspricht,
- eine Halbleiterantriebsvorrichtung (366), die mit dem Steueranschluss elektrisch verbunden ist, um den Energieausgangsanschluss in Abhängigkeit vom Steuersignal zum Betreiben einer Lampe des Hilfsbeleuchtungssystems, die der Lampe des Fahrzeugbeleuchtungssystems entspricht, selektiv anzutreiben, wobei das Steuersignal in einem Antriebszustand ist, der mindestens aus einem angetriebenen und einem nicht angetriebenen Zustand ausgewählt ist,
- eine Messschaltung (365) zum Erhalten eines Messwerts mindestens eines elektrischen Parameters, der eine Leistung der Lampe des Hilfsbeleuchtungssystems während mindestens eines Teils des angetriebenen Zustands angibt,
- eine drahtlose Schnittstelle (361, 362) zur Kommunikation mit einer entfernten Benutzervorrichtung (400), die extern zu dem Fahrzeug und dem Hilfsbeleuchtungssystem ist, und
- einen Prozessor (364), der zum Senden, über die drahtlose Schnittstelle, eines Signals, das den Messwert des mindestens einen elektrischen Parameters angibt, an die Benutzervorrichtung eingerichtet ist, um der Benutzervorrichtung zu ermöglichen, einen Benutzer über den Messwert des mindestens einen elektrischen Parameters oder einen davon abgeleiteten Indikator zu informieren;
- wobei die Benutzervorrichtung (400) umfasst:
- eine drahtlose Schnittstelle der Benutzervorrichtung zum Empfangen des Signals, das den Messwert des mindestens einen elektrischen Parameters angibt, von einer solchen Art eines Schnittstellenmoduls (360), einem Messmodul (1360) nach einem der vorstehenden Ansprüche, oder einem Fahrzeug (C), das ein Fahrzeugbeleuchtungssystem (110) und ein solches Schnittstellenmodul (360) umfasst, wobei das Schnittstellenmodul eingerichtet ist, um ein Hilfsbeleuchtungssystem (210), wie etwa ein Anhängerbeleuchtungssystem, mit dem Fahrzeugbeleuchtungssystem des Fahrzeugs zu verbinden und, wenn verbunden, um das Hilfsbeleuchtungssystem von dem Fahrzeugbeleuchtungssystem anzutreiben;
- einen Signalprozessor, der eingerichtet ist, um das Signal, wie es von der drahtlosen Schnittstelle der Benutzervorrichtung empfangen wird, zu verarbeiten und um einen Indikator des Messwerts des mindestens einen elektrischen Parameters abzuleiten; und
- eine Indikatorvorrichtung, die eingerichtet ist, um einen Benutzer über den Indikator zu informieren, wobei die Indikatorvorrichtung wahlweise mindestens eines umfasst von:
- einer Vorrichtung eines visuellen Indikators, wie etwa eine elektronische Anzeige und/oder ein Indikatorlicht, und
- einer Vorrichtung eines hörbaren Indikators, wie etwa einen Lautsprecher, der eingerichtet ist, um ein Ton, ein abgerufenes gesprochenes Wort, eine abgerufene gesprochene Nachricht, ein synthetisiertes gesprochenes Wort oder eine synthetisierte gesprochene Nachricht bereitzustellen,
- wobei der Signalprozessor wahlweise eingerichtet ist, um den Messwert in einem lokalen Speicher der Benutzervorrichtung zu speichern und/oder den Messwert über ein drahtloses Kommunikationsnetzwerk (2500) an eine entfernte Benutzeraustauschvorrichtung (2000) zu übertragen; und
- wobei das Messmodul (1360) ein Messmodul nach einem der Ansprüche 1-2 ist.

5. Ein Testsystem nach Anspruch 4,weiter umfassend eine Benutzeraustauschvorrichtung (2000), die eingerichtet ist, um Testergebnisse von der Benutzervorrichtung (400) und/oder dem Messmodul (1360) über ein drahtloses Kommunikationsnetzwerk (2500) zu empfangen und um Informationen an einen Benutzer der Benutzeraustauschvorrichtung (2000) mittels einer Anzeige (2006) visuell bereitzustellen.

## Revendications

1. Un module de mesure (1360) comprenant un circuit de mesure pour obtenir une valeur de mesure d'un signal de commande de lampe de remorque au cours d'au moins une partie d'un état commandé et une interface sans fil pour transmettre un signal indicatif de la valeur de mesure d'au moins un paramètre électrique du signal de commande de lampe de remorque à un dispositif d'utilisateur pour permettre au dispositif d'utilisateur d'informer un utilisateur de la valeur de mesure de l'au moins un paramètre électrique ou d'un indicateur dérivé de celle-ci,
- le module de mesure (1360) pouvant être relié à un raccordement de sortie (3711) d'un module d'interface (360) pour recevoir le signal de commande de lampe de remorque depuis le raccordement de sortie sélectivement commandé,
- le module d'interface (360) étant compris dans un dispositif d'interface (300) pour relier un système d'éclairage auxiliaire à un système d'éclairage de véhicule d'un véhicule et commander le système d'éclairage auxiliaire depuis le système d'éclairage de véhicule, le module d'interface comprenant :
- le raccordement de puissance de sortie (3711) à relier électriquement au système d'éclairage auxiliaire via un câble de crochet de remorque,
- un raccordement de contrôle (3401) à relier électriquement au système d'éclairage de véhicule pour recevoir un signal de contrôle correspondant à un fonctionnement d'une lampe du système d'éclairage de véhicule,
- un dispositif semiconducteur de commande (366) relié électriquement au raccordement de contrôle pour commander sélectivement le raccordement de puissance de sortie en fonction du signal de contrôle pour faire fonctionner une lampe du système d'éclairage auxiliaire correspondant à la lampe du système d'éclairage de véhicule, le signal de contrôle étant dans un état de commande sélectionné parmi au moins un état commandé et un état non commandé,
- un circuit de mesure (365) pour obtenir une valeur de mesure d'au moins un paramètre électrique indicatif d'une performance de la lampe du système d'éclairage auxiliaire au cours d'au moins une partie de l'état commandé,
- une interface sans fil (361, 362) pour communiquer avec un dispositif d'utilisateur distant (400) à l'extérieur du véhicule et le système d'éclairage auxiliaire, et
- un processeur (364) agencé pour envoyer, via l'interface sans fil, un signal indicatif de la valeur de mesure de l'au moins un paramètre électrique au dispositif d'utilisateur pour permettre au dispositif d'utilisateur d'informer un utilisateur de la valeur de mesure de l'au moins un paramètre électrique ou d'un indicateur dérivé de celle-ci.

2. Un module de mesure selon la revendication 1, le module de mesure comprenant en outre un processeur agencé pour envoyer des signaux de contrôle de test via l'interface sans fil (1362) audit module d'interface pour réaliser une procédure de test.

3. Un boîtier de mesure, le boîtier de mesure (M) comprenant un module de mesure (1360) selon l'une quelconque des revendications 1-2, un câble de mesure (1230) et une fiche côté mesure comprenant un ou plusieurs raccordements de mesure (1212), le module de mesure étant relié via le câble de mesure aux raccordements de mesure, la fiche côté mesure pouvant être insérée dans une prise de crochet de remorque (380).

4. Un système de test comprenant un module d'interface électronique (360), un dispositif d'utilisateur (400), et un module de mesure (1360),
- le module d'interface (360) étant compris dans un dispositif d'interface (300) pour relier un système d'éclairage auxiliaire à un système d'éclairage de véhicule d'un véhicule et commander le système d'éclairage auxiliaire depuis le système d'éclairage de véhicule, le module d'interface comprenant :
- un raccordement de puissance de sortie (3711) à relier électriquement au système d'éclairage auxiliaire via un câble de crochet de remorque,
- un raccordement de contrôle (3401) à relier électriquement au système d'éclairage de véhicule pour recevoir un signal de contrôle correspondant à un fonctionnement d'une lampe du système d'éclairage de véhicule,
- un dispositif semiconducteur de commande (366) relié électriquement au raccordement de contrôle pour commander sélectivement le raccordement de puissance de sortie en fonction du signal de contrôle pour faire fonctionner une lampe du système d'éclairage auxiliaire correspondant à la lampe du système d'éclairage de véhicule, le signal de contrôle étant dans un état de commande sélectionné parmi au moins un état commandé et un état non commandé,
- un circuit de mesure (365) pour obtenir une valeur de mesure d'au moins un paramètre électrique indicatif d'une performance de la lampe du système d'éclairage auxiliaire au cours d'au moins une partie de l'état commandé,
- une interface sans fil (361, 362) pour communiquer avec un dispositif d'utilisateur distant (400) à l'extérieur du véhicule et le système d'éclairage auxiliaire, et
- un processeur (364) agencé pour envoyer, via l'interface sans fil, un signal indicatif de la valeur de mesure de l'au moins un paramètre électrique au dispositif d'utilisateur pour permettre au dispositif d'utilisateur d'informer un utilisateur de la valeur de mesure de l'au moins un paramètre électrique ou d'un indicateur dérivé de celle-ci ;
- le dispositif d'utilisateur (400) comprenant :
- une interface sans fil de dispositif d'utilisateur pour recevoir le signal indicatif de la valeur de mesure de l'au moins un paramètre électrique depuis un tel type d'un module d'interface (360), d'un module de mesure (1360) selon l'une quelconque des revendications précédentes, ou d'un véhicule (C) comprenant un système d'éclairage de véhicule (110) et un tel module d'interface (360), le module d'interface étant agencé pour relier un système d'éclairage auxiliaire (210), comme un système d'éclairage de remorque, au système d'éclairage de véhicule du véhicule et pour, lorsqu'il est relié, commander le système d'éclairage auxiliaire depuis le système d'éclairage de véhicule ;
- un processeur de signal agencé pour traiter le signal tel que reçu par l'interface sans fil de dispositif d'utilisateur et dériver un indicateur de la valeur de mesure de l'au moins un paramètre électrique ; et
- un dispositif indicateur agencé pour informer un utilisateur de l'indicateur, dans lequel le dispositif indicateur comprend facultativement au moins l'un parmi :
- un dispositif indicateur visuel, comme un affichage électronique et/ou un voyant indicateur, et
- un dispositif indicateur audible, comme un haut-parleur agencé pour fournir un son, un mot parlé récupéré, un message parlé récupéré, un mot parlé synthétisé ou un message parlé synthétisé,
dans lequel le processeur de signal est facultativement agencé pour stocker la valeur de mesure dans une mémoire locale du dispositif d'utilisateur et/ou transférer la valeur de mesure à un dispositif d'interaction d'utilisateur distant (2000) via un réseau de communication sans fil (2500) ; et
- le module de mesure (1360) étant un module de mesure selon l'une quelconque des revendications 1-2.

5. Un système de test selon la revendication 4, comprenant en outre un dispositif d'interaction d'utilisateur (2000) agencé pour recevoir des résultats de test depuis le dispositif d'utilisateur (400) et/ou le module de mesure (1360) via un réseau de communication sans fil (2500) et fournir visuellement des informations à un utilisateur du dispositif d'interaction d'utilisateur (2000) au moyen d'un affichage (2006).
